# EUROPÄISCHE PATENTSCHRIFT

(11) **EP 1 536 372 B1**
(45) Veröffentlichungstag und Bekanntmachung des Hinweises auf die Patenterteilung: **02.08.2006**
(21) Anmeldenummer: 03405839.6
(22) Anmeldetag: 25.11.2003
(51) Int. Cl.: G06K 19/077, H05K 13/00

(54) **Verfahren zur Herstellung von Datenträgern und nach diesem Verfahren hergestellter Datenträger**
Method of manufacturing data carriers and the data carrier obtained by this method
Procédé de fabrication d'un support de données et le support de données fabriqué selon ce procédé

(43) Veröffentlichungstag der Anmeldung: 01.06.2005
(73) Patentinhaber: Trüb AG, CH-5001 Aarau (CH)
(72) Erfinder: Christen, Paul, 5000 Aarau (CH); Hahn, Roland, 4600 Olten (CH)
(74) Vertreter: Groner, Manfred

(56) Entgegenhaltungen:
- DE-A1- 10 122 416
- DE-A1- 19 645 083
- DE-C1- 19 505 245
- DE-C1- 19 720 226
- FR-A1- 2 798 873

## Beschreibung

Die Erfindung betrifft ein Verfahren zur Herstellung von Datenträgern nach dem Oberbegriff des Anspruchs 1. Die Erfindung betrifft zudem einen nach diesem Verfahren hergestellten Datenträger.

Bei der Herstellung von Chip-Karten wird ein Chipmodul in den Kartenkörper implantiert und dieses wird elektrisch und mechanisch mit einer in der Karte eingebetteten Antenne verbunden. Hiermit können Datenträger mit einer so genannten Dual-Funktion hergestellt werden, bei welcher das implantierte Chipmodul sowohl über eine Kontaktfläche als auch berührungslos über die Antenne ansprechbar ist.

Der Körper für solche Datenträger bzw. Chip-Karten wird insbesondere durch Laminieren mehreren Schichten hergestellt. Die Antenne ist eine geäzte, gedruckte, gewickelte oder gelegte Spule, die auf einer dieser Schichten angeordnet ist.

Das Implantieren des Chipmoduls kann bei der Herstellung von Datenträgern mit Dual-Funktion im Wesentlichen gleich erfolgen, wie bei der Herstellung einer üblichen Bankkarte. Hierbei wird eine Rohkarte für das Chipmodul ausgefräst und anschliessend wird das Chipmodul in diese Vertiefung hineingeklebt. Diese Vertiefung wird auch Kavitätsfräsung genannt. Soll ein Datenträger mit Dual-Funktion hergestellt werden, so muss die Antenne elektrisch und mechanisch mit dem Chipmodul verbunden werden. Nach einem Stand der Technik wird die Antenne selbst oder Anschlüsse zur Antenne freigefräst und hierbei wird die Antenne oder die Anschlüsse zur Antenne angefräst. Mit einer elektrisch leitenden Paste wird dann das Chipmodul mit der Antenne elektrisch verbunden. Bei diesem Verfahren besteht die Schwierigkeit, dass die angefräste Antenne bzw. die angefrästen Anschlüsse oxidieren können und die elektrische Leitfähigkeit und damit die Funktionssicherheit gestört oder verhindert werden.

Im Stand der Technik sind zudem die nachfolgenden Verfahren bekannt geworden, mit denen ein Kontakt einer Chip-Karte hergestellt werden soll.

Die DE-A-101 22 416 offenbart ein Verfahren zur Herstellung einer Chipkarte mit Spule, wobei eine Verbindung zwischen der Spule und den Anschlussflächen eines integrierten Schaltkreises hergestellt wird. Die Verbindung wird mit einer Metallfolie hergestellt, die freigefräst und auch leicht angefräst wird. Das Anfräsen der Metallfolie kann jedoch eine einwandfreie Kontaktierung beeinträchtigen.

Die DE 197 28 993 C offenbart ein Verfahren zur Herstellung einer Chip-Karte mit einer eingebetteten Antenne, wobei der Kontakt zwischen dem Chipmodul und der Antenne durch einen elektrisch leitenden Stift hergestellt wird, der so weit in die Chip-Karte eingetrieben wird, dass sein vorderes Ende kraftschlüssig mit der Antenne verbunden wird. Der Stift ist vorzugsweise aus Aluminium hergestellt. Auch hier dürfte die Dauerhaftigkeit aufgrund von Oxidationen begrenzt sein.

Die WO 99/21131 offenbart ebenfalls ein Verfahren zur Herstellung von Chip-Karten, wobei über eine elektrisch leitfähige Masse wie Leitklebstoff oder dergleichen das Chipmodul mit der Antenne verbunden wird. Diese leitfähige Masse wird mittels einer Dosiereinrichtung auf die zweite Kontaktfläche aufgetragen.

Die WO 98/08191 befasst sich ebenfalls mit einem Verfahren zur Herstellung einer elektrischen und mechanischen Verbindung in einer Chip-Karte, die Verbindung wird unter Verwendung eines Heiss- und Schmelzklebers hergestellt, wobei eine zusätzliche leitfähige Schicht oder leitfähige Partikel verwendet werden.

Der Erfindung liegt die Aufgabe zugrunde, ein Verfahren der genannten Art zu schaffen, das die genannten Schwierigkeiten vermeidet und eine dauernde elektrische Verbindung insbesondere zwischen einem Chipmodul und einer Antenne bei hoher Einsatzdauer gewährleistet.

Die Aufgabe ist bei einem gattungsgemässen Verfahren gemäss Anspruch 1 gelöst. Da die Edelmetallschicht vertieft angeordnet ist, kann diese ohne Beschädigung freigelegt werden. Die Edelmetallschicht kann vergleichsweise dünn sein, da sie beim Abtragen des Kartenkörpers nicht beschädigt, beispielsweise angefräst wird. Da nur geringe Mengen eines Edelmetalls, beispielsweise Gold erforderlich sind, um eine solche Schicht herzustellen, sind die zusätzlichen Kosten für diese Schicht vergleichsweise gering. Da die Kontaktfläche, welche durch die Edelmetallschicht gebildet wird, im Gegensatz zu Kupfer oder anderen Buntmetallen nicht oxidiert, kann die elektrische Leitfähigkeit dieser Kontaktstelle und damit die Funktionssicherheit nicht gestört oder verhindert werden. Mit dem erfindungsgemässen Verfahren kann somit in einem Datenträger und insbesondere in einer Chip-Karte eine Kontaktfläche geschaffen werden, die frei von Oxidation ist und die trotzdem keine wesentlich höheren Kosten verursacht.

Es ist vorgesehen, dass die Edelmetallschicht auf einer in den Kartenkörper eingebetteten Kontaktbrücke angeordnet ist. Diese Kontaktbrücke ist beispielsweise an einer Antenne angelötet und befindet sich zwischen laminierten Schichten des Kartenkörpers. Die Kontaktbrücke wird so in den Kartenkörper eingebettet, dass sie sich nach der Herstellung der Rohkarte immer auf der gleichen Position der X- und Y-Achse der Karte befindet. Beim Herstellen der Kavität für das Chipmodul kann dann gleichzeitig die genannte Edelmetallschicht freigelegt werden.

Nach einer Weiterbildung der Erfindung wird die Edelmetallschicht mit einem Fräswerkzeug freigelegt. Vorzugsweise weist das Fräswerkzeug eine detektierende Einheit auf und es wird so gefräst, dass die Edelmetallschicht nicht touchiert wird. Die detektierende Einheit ermöglicht es, das Fräswerkzeug exakt so weit in den Körper einzutauchen, dass der Kontaktkörper und insbesondere die Kontaktbrücke leicht touchiert wird.

Da die Edelmetallschicht vertieft angeordnet ist, wird diese hierbei nicht angefräst und bleibt somit unverletzt. In der Vertiefung über der Metallschicht vergleichende Reste werden nach einer Weiterbildung der Erfindung abgesaugt.

Nachfolgend wird die Erfindung anhand der Zeichnung näher erläutert. Es zeigen:
- Figur 1: schematisch eine Ansicht eines erfindungsgemässen Datenträgers,
- Figur 2: ein stark vergrösserter Ausschnitt aus der Figur 1,
- Figur 3: ein Schnitt entlang der Linie III-III der Figur 1 und
- Figuren 4-7: schematisch einzelne Verfahrensschritte.

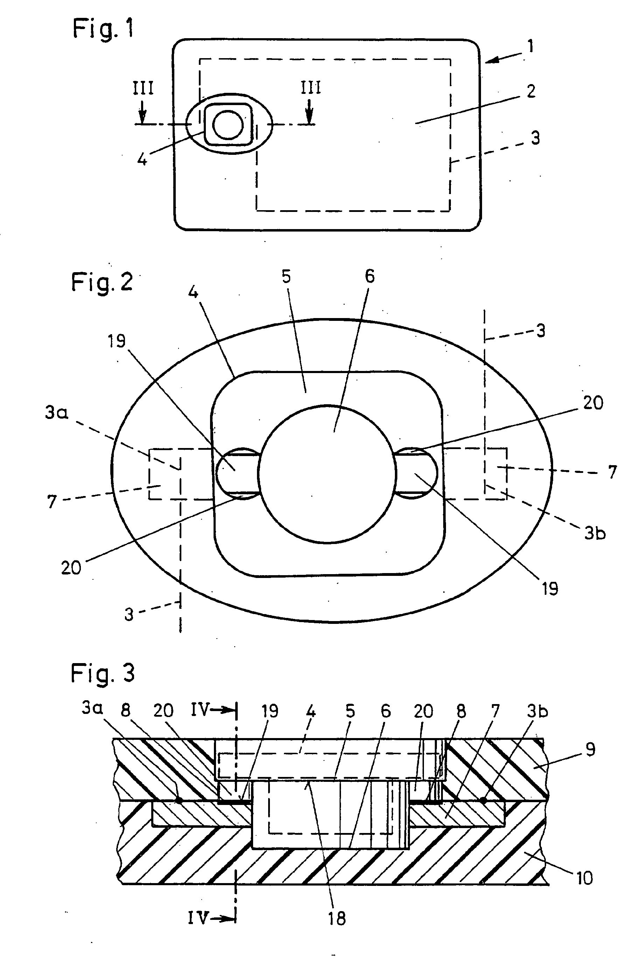

Die Figur 1 zeigt einen Datenträger 1, der ein an sich bekanntes Chipmodul 4 aufweist, welcher in die in Figur 3 gezeigten Kavitäten 5 und 6 eingebettet ist. Die Befestigung des Chipmoduls 4 in die Kavitäten 5 und 6 erfolgt in an sich bekannter Weise beispielsweise mit einem Klebstoff. Das Chipmodul 4 ist mit einer Antenne 3 verbunden, die vorzugsweise in einen Kartenkörper 2 eingebettet ist. Die Antenne 3 ist beispielsweise eine geäzte, gedruckte, gewickelte oder gelegte Spule aus Kupfer. Sie ist gemäss Figur 3 auf einer unteren Schicht 10 des Kartenkörpers 2 angeordnet und diese Schicht 10 ist mit einer darüber liegenden weiteren Schicht 9 verbunden. Die beiden Schichten 9 und 10 sind beispielsweise durch Laminieren miteinander verbunden. Grundsätzlich kann der Körper 2 auch noch weitere hier nicht gezeigte Schichten aufweisen. Die Schichten 9 und 10 sind vorzugsweise Kunststoffschichten, beispielsweise aus Polycarbonat oder PVC.

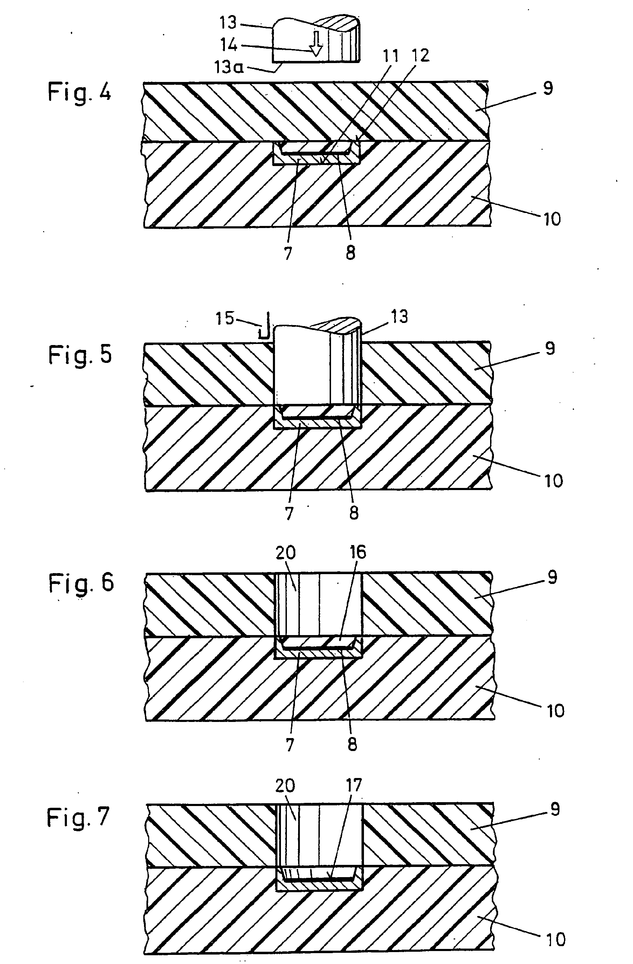

Die beiden Enden 3a und 3b der Antenne 3 sind gemäss Figur 2 mit einer Kontaktbrücke 7 elektrisch und mechanisch verbunden. Die Verbindung erfolgt beispielsweise durch Löten. Die Kontaktbrücke 7 ist gemäss Figur 3 in die Schicht 10 eingelegt und weist in einer nutenförmigen Vertiefung 19 eine Edelmetallschicht 8 auf. Die Edelmetallschicht 8 besteht beispielsweise und vorzugsweise aus Gold ist und vergleichsweise dünn und ist auf eine ebene Fläche 11 der Vertiefung 19 aufgetragen, wie die Figur 4 zeigt. Die Edelmetallschicht 8 bildet eine erste Kontaktfläche 17.

Die genannten beiden Kavitäten 5 und 6 sind so angeordnet, dass diese sich über der Kontaktbrücke 7 befinden, wobei eine zweite Kavität 6 so hergestellt ist, dass sie die Kontaktbrücke 7 gemäss Figur 3 durchbricht. Die erste Kavität 5 ist weniger tief, jedoch breiter und erstreckt sich über die von einander getrennten Edelmetallschichten 8. In der Figur 3 ist gestrichelt das in die Kavitäten 5 und 6 eingelegte Chipmodul 4 angedeutet. In den Kartenkörper 2 sind zwei Ausfräsungen 20 eingearbeitet, welche den Kartenkörper 2 über den Edelmetallschichten 8 freilegen. Diese Ausfräsungen 20 werden insbesondere mit einem geeigneten Fräser hergestellt. Zur elektrischen und mechanischen Verbindung der Edelmetallschichten 8 mit Kontaktflächen 18 des Chipmoduls 4 wird die Ausfräsung 20 mit einer Kontaktpaste ausgefüllt. Die Verbindungen des Chipmoduls 4 zur Antenne 3 erfolgt somit über diese Kontaktpaste, die Edelmetallschichten 8 sowie über die Kontaktbrücke 7 und die Lötstellen an den Enden 3a und 3b der Antenne 3. Die Kontaktflächen 18 des Chipmoduls 4 können ebenfalls durch hier nicht gezeigte Edelmetallschichten gebildet sein.

Nachfolgend wird das Verfahren zur Herstellung des Datenträgers 1 näher erläutert.

Vor dem Laminieren wird auf der Schicht 10 die Kontaktbrücke 7 befestigt und mit der Antenne 3 an ihren Enden 3a und 3b elektrisch und mechanisch verbunden. Das Verbinden erfolgt beispielsweise durch Löten. Die Kontaktbrücke 7 wird genau in der Position angeordnet, in welcher später das Chipmodul 4 montiert wird.

Sind die Kontaktbrücke 7 und die Antenne 3 gelegt, so werden die beiden Schichten 9 und 10 beispielsweise durch Laminieren miteinander verbunden. Nun werden die beiden Kavitäten 5 und 6 mit einem geeigneten Werkzeug, beispielsweise mit einem Fräser hergestellt. Durch die zweite Kavität 6 wird die Kontaktbrücke 7 getrennt. Nun werden die beiden Ausfräsungen 20 gemäss den Figuren 4 bis 6 mit einem geeigneten Werkzeug 13 hergestellt. Das Werkzeug 13 wird gemäss Figur 4 in Richtung des Pfeils 14 von oben in die Schicht 9 so weit eingetaucht, bis eine Frontseite 13a des Werkzeuges 13 eine Oberseite 12 der Kontaktbrücke 7 knapp touchiert. Wesentlich ist nun, dass die Edelmetallschicht 8 hierbei nicht abgefräst wird. Diese Edelmetallschicht 8 befindet sich in der Vertiefung 19 und ist somit unterhalb der Oberseite 12 angeordnet und gegen einen Abtrag geschützt. Damit das Werkzeug 13 beim Fräsen rechtzeitig gestoppt werden kann, weist das Werkzeug 13 gemäss Figur 5 eine an sich bekannte Detektiereinheit 15 auf, welche auf die Kontaktbrücke 7 anspricht und ein Signal abgibt, sobald das Werkzeug 13 die Kontaktbrücke 7 berührt.

In der Vertiefung 19 kann über der Edelmetallschicht 8 ein Rest 16 vorhanden sein, der vorzugsweise abgesaugt wird. Die Edelmetallschicht 8 ist schliesslich gemäss Figur 7 freigelegt.

Beide Ausfräsungen 20 werden wie oben erläutert hergestellt. Sie können gleichzeitig mit zwei parallel geführten Werkzeugen 13, beispielsweise mit zwei Fräsköpfen hergestellt werden.

Auf die freigelegten Edelmetallschichten 8 wird nun eine hier nicht gezeigte Kontaktpaste aufgetragen. Die Kontaktpaste ist so dosiert, dass sie die zweite Kavität 6 überragt. Beim Implantieren des Chipmoduls 4 wird diese Kontaktpaste in die Ausfräsungen 20 und in die Vertiefungen 19 hineingepresst und dadurch wird eine dauernde Verbindung zwischen den zweiten Kontaktflächen 18 des Chipmoduls 4 und den ersten Kontaktflächen 17 der Kontaktbrücke 7 hergestellt. Mit einem Kleber, beispielsweise einem Hot-Melt-Kleber wird nun das Chipmodul 4 mechanisch in den Kavitäten 5 und 6 befestigt.

Bei den üblichen zur Herstellung von Chip-Karten verwendeten Chipmodulen 4 sind die Kontaktflächen ebenfalls mit einer Edelmetallbeschichtung versehen. Beim erfindungsgemässen Datenträger kann deshalb keine Oxidation bei den Verbindungen zwischen dem Chipmodul 4 und der Antenne 3 entstehen. Eine dauernde elektrische Verbindung über eine hohe Einsatzdauer von beispielsweise 10 Jahren kann dadurch sichergestellt werden.

### Bezugszeichenliste

- 1.: Datenträger
- 2.: Kartenkörper
- 3.: Antenne
- 3.a: Ende
- 3.b: Ende
- 4.: Chipmodul
- 5.: erste Kavität
- 6.: zweite Kavität
- 7.: Kontaktbrücke
- 8.: Edelmetall
- 9.: Kartenschicht
- 10.: Kartenschicht
- 11.: ebene Fläche der Kontaktbrücke
- 12.: Oberseite der Kontaktbrücke
- 13.: Werkzeug
- 13.a: Frontseite
- 14.: Pfeil
- 15.: Detektiereinheit
- 16.: Rest
- 17.: erste Kontaktfläche
- 18.: zweite Kontaktfläche
- 19.: Vertiefung
- 20.: Ausfräsung

## Patentansprüche

1. Verfahren zur Herstellung von Datenträgern (1), bei denen wenigstens eine erste Kontaktfläche (17) eines ersten Bauteils (3, 7), der eine Antenne (3) und eine mit dieser verbundene Kontaktbrücke (7) aufweist, mit einer zweiten Kontaktfläche (18) eines in einen Körper (2) des Datenträgers (1) eingebetteten zweiten Bauteils (4) elektrisch und mechanisch verbunden wird, die erste Kontaktfläche (17) durch eine vertieft angeordnete und in den Körper (2) eingebettete Edelmetallschicht (8) gebildet wird und dass diese Edelmetallschicht (8) mit einem Werkzeug (13) freigelegt wird, wobei ein Bereich des Körpers (2) über der Edelmetallschicht (8) abgetragen wird und dass die freigelegte Edelmetallschicht (8) mit der zweiten Kontaktfläche (18) elektrisch und mechanisch verbunden wird, **dadurch gekennzeichnet, dass** die Edelmetallschicht (8) in einer Vertiefung der Kontaktbrücke (7) unterhalb der Oberseite der mit der Antenne verbundenen Kontaktbrücke (7) angeordnet wird, wobei die Edelmetallschicht in folgenden Schritten freigelegt wird:
- das Werkzeug entfernt einen Bereich des Kartenkörpers, bis zur genannten Oberseite der Kontaktbrücke (7),
- die in der Vertiefung über der Edelmetallschicht verbleibende Resten des Kartenkörpers werden entfernt.

2. Verfahren nach Anspruch 1, **dadurch gekennzeichnet, dass** das Werkzeug mit der genannten Oberseite der Kontaktbrücke (7) in Berührung kommt.

3. Verfahren nach Anspruch 1 oder 2, **dadurch gekennzeichnet, dass** die Edelmetallschicht (8) mit einem Fräswerkzeug (13) freigelegt wird.

4. Verfahren nach Anspruch 3, **dadurch gekennzeichnet, dass** das Fräswerkzeug (13) eine Detektiereinheit (15) aufweist, welche auf die Kontaktbrücke (7) anspricht und ein Signal abgibt, sobald das Werkzeug (13) die Kontaktbrücke berührt.

5. Verfahren nach einem der Ansprüche 1 bis 4, **dadurch gekennzeichnet, dass** die nach dem Abtragen über der Edelmetallschicht (8) verbleibende Resten (16) des Kartenkörpers abgesaugt werden.

6. Datenträger hergestellt nach dem Verfahren gemäss Anspruch 1, **dadurch gekennzeichnet, dass** er eine Chip-Karte ist und dass die Edelmetallschicht in der Vertiefung der Kontaktbrücke (7) ohne Beschädigung ist und dass die Oberseite der Kontaktbrücke über der Vertiefung angefräst ist.

7. Datenträger gemäss Anspruch 6, **dadurch gekennzeichnet, dass** die Edelmetallschicht (8) aus Gold ist.

## Claims

1. Method of manufacturing data carriers (1), in which at least a first contact surface (17) of a first component (3, 7), which has an antenna (3) and a contact bridge (7) connected to the latter, is electrically and mechanically connected to a second contact surface (18) of a second component (4) embedded in a body (2) of the data carrier (1), the first contact surface (17) is formed by a precious metal layer (8) arranged in a recessed manner and embedded in the body (2) and this precious metal layer (8) is laid bare with a tool (13), a region of the body (2) over the precious metal layer (8) being removed and the laid-bare precious metal layer (8) being electrically and mechanically connected to the second contact surface (18), **characterized in that** the precious metal layer (8) is arranged in a recess of the contact bridge (7) underneath the upper side of the contact bridge (7) connected to the antenna, the precious metal layer being laid bare in the following steps:
- the tool removes a region of the card body as far as the said upper side of the contact bridge (7),
- the remains of the card body remaining in the recess over the precious metal layer are removed.

2. Method according to Claim 1, **characterized in that** the tool comes into contact with the said upper side of the contact bridge (7).

3. Method according to Claim 1 or 2, **characterized in that** the precious metal layer (8) is laid bare with a milling tool (13).

4. Method according to Claim 3, **characterized in that** the milling tool (13) has a detecting unit (15), which responds to the contact bridge (7) and emits a signal as soon as the tool (13) touches the contact bridge.

5. Method according to one of Claims 1 to 4, **characterized in that** the remains (16) of the card body remaining over the precious metal layer (8) after removal are sucked away.

6. Data carrier manufactured by the method according to Claim 1, **characterized in that** it is a chip card and **in that** the precious metal layer is undamaged in the recess of the contact bridge (7) and **in that** the upper side of the contact bridge over the recess is milled.

7. Data carrier according to Claim 6, **characterized in that** the precious metal layer (8) is of gold.

## Revendications

1. Procédé de fabrication de supports de données (1), avec lequel au moins une première surface de contact (17) d'un premier composant (3, 7), qui présente une antenne (3) et un cavalier de contact (7) relié avec celle-ci, est reliée électriquement et mécaniquement avec une deuxième surface de contact (18) d'un deuxième composant (4) enrobé dans un corps (2) du support de données (1), la première surface de contact (17) est formée par une couche de métal précieux (8) disposée en retrait et enrobée dans le corps (2) et que cette couche de métal précieux (8) est dégagée avec un outil (13), une zone du corps (2) au-dessus de la couche de métal précieux (8) étant enlevée et que la couche de métal précieux (8) dégagée est reliée électriquement et mécaniquement avec la deuxième surface de contact (18), **caractérisé en ce que** la couche de métal précieux (8) est disposée dans un enfoncement du cavalier de contact (7) sous le côté supérieur du cavalier de contact (7) relié avec l'antenne, la couche de métal précieux étant dégagée lors des étapes suivantes :
- l'outil enlève une zone du corps de la carte jusqu'audit côté supérieur du cavalier de contact (7),
- les restes du corps de la carte qui demeurent dans l'enfoncement au-dessus de la couche de métal précieux sont enlevés.

2. Procédé selon la revendication 1, **caractérisé en ce que** l'outil entre en contact avec ledit côté supérieur du cavalier de contact (7).

3. Procédé selon la revendication 1 ou 2, **caractérisé en ce que** la couche de métal précieux (8) est dégagée avec un outil de fraisage (13).

4. Procédé selon la revendication 3, **caractérisé en ce que** l'outil de fraisage (13) présente une unité de détection (15) qui réagit à la présence du cavalier de contact (7) et émet un signal dès que l'outil (13) touche le cavalier de contact.

5. Procédé selon l'une des revendications 1 à 4, **caractérisé en ce que** les restes (16) du corps de la carte qui demeurent au-dessus de la couche de métal précieux (8) après l'enlèvement sont aspirés.

6. Support de données fabriqué d'après le procédé selon la revendication 1, **caractérisé en ce qu'**il est une carte à puce et que la couche de métal précieux se trouve dans l'enfoncement du cavalier de contact (7) sans dommage et que le côté supérieur du cavalier de contact est fraisé au-dessus de l'enfoncement.

7. Support de données selon la revendication 6, **caractérisé en ce que** la couche de métal précieux (8) est en or.
